# EUROPEAN PATENT APPLICATION

(11) **EP 2 800 150 A1**
(43) Date of publication of application: **05.11.2014**
(21) Application number: 11878703.5
(22) Date of filing: 27.12.2011
(51) Int. Cl.: H01L 31/052

(54) **PHOTOVOLTAIC SOLAR CONCENTRATION MODULE**

(71) Applicant: Teknia Manufacturing Group, S.L., 23600 Martos (Jaén) (ES)
(72) Inventor: PARRAS PADILLA, Miguel Ángel, E-23600 Martos (Jaén) (ES); ÓRPEZ RUBIA, Antonio Jesús, E-23600 Martos (Jaén) (ES); PARRAS PADILLA, Miguel Ángel, E-23600 Martos (Jaén) (ES); ÓRPEZ RUBIA, Antonio Jesús, E-23600 Martos (Jaén) (ES)
(74) Representative: Capitán García, Maria Nuria
(86) International application number: PCT/ES2011/070909
(87) International publication number: WO 2013/098426

(57) **Abstract**

The Present invention relates to a photovoltaic solar concentration module that has a plastic housing which means that solar rays can never be concentrated in certain areas of the inner surface of the housing that are not protected from solar radiation, with the result that said zones are never burnt, and therefore the interior surface of the photovoltaic solar concentration module does not need to be covered with metallic plates over its entire surface since that are zones thereof that are always accessible to solar rays.

## Description

### OBJECT OF THE INVENTION

The present invention relates to a photovoltaic solar concentration module that has a plastic housing whereby sunlight can never concentrate on certain areas of the inner surface of the housing that are not protected from solar radiation, such that they are never burnt.

Because of its special configuration, the inner surface of the photovoltaic solar concentration module does not have to be entirely covered with metallic plates, as some areas thereof are never reached by the sunlight.

In addition, the ratio of the focal length of the lenses arranged in the module to their radius remains constant, which allows isolating from the sunlight the areas that are not covered with metallic plates.

### BACKGROUND OF THE INVENTION

The prior art includes photovoltaic solar concentration modules which use lenses to concentrate sunlight that is incident on photovoltaic cells placed at their focal point. These lenses are installed on plastic and/or metallic bodies.

There exist several types of modules, but most have mechanisms that allow aiming them at the sun at all times such that the sunlight is incident perpendicular to the capture area, where the concentration lenses are located.

Said concentrator lenses are made on the same plastic plate of the photovoltaic solar concentration module; there can be one or several lenses, such that the modules that include them have different sizes.

The technical drawback of this type of modules is that when a malfunction causes the sun tracking system to fail and the sunlight is not incident perpendicularly on the lenses, the concentration is not performed on the photovoltaic cells but on any other point of the module, thereby burning it, such that it is damaged and rendered useless. This drawback has been solved hitherto by placing metallic plates to protect the inner plastic walls of the photovoltaic module, but this solution increases the cost of the module.

Some of these modules are available in the market with a plastic base that includes orifices allowing the photovoltaic cells to pass, which are housed in a metallic sheet anchored on its bottom to the base of the module.

The present invention solves the aforementioned drawbacks related to burning and deterioration of the modules.

### DESCRIPTION OF THE INVENTION

The object of the present invention is a photovoltaic solar concentration module that has a plastic housing whereby sunlight can never be concentrated in certain areas of the inner surface of the housing that are not protected from the solar radiation, such that they are never burned.

The housing of the photovoltaic solar concentration module has the shape of two truncated pyramids joined at their minor base, such that the inner surface of the photovoltaic solar concentration module is only covered by metallic plates in the bottom truncated pyramid, which is the area reached by solar radiation.

On the top part of the module, the greater base of the top truncated pyramid, a set of lenses is arranged that allows converging sunlight towards a group of photovoltaic cells arranged inside the module, in the other base of the other truncated pyramid.

Since the ratio of the focal length of the lenses arranged in the module to their radius remains constant, the sunlight is only incident on the inner surface of the bottom truncated pyramid if the solar concentration module does not track the sun correctly.

### DESCRIPTION OF THE DRAWINGS

The present specification is complemented by a set of drawings that illustrate a preferred embodiment and in no way limit the invention.

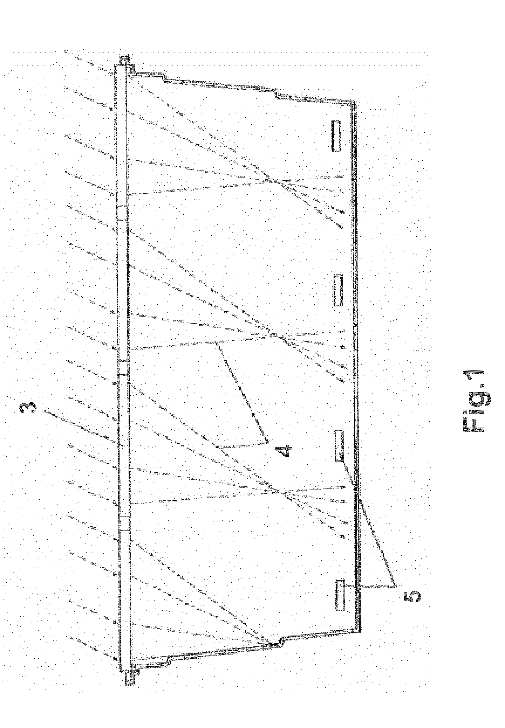

Figure 1 shows a cross-section of a photovoltaic solar concentration module of the prior art with the sunlight reaching the inner walls of said module when it is not incident perpendicular to the lenses.
Figure 2 shows a perspective view of a first example of embodiment of a photovoltaic solar concentration module according to the invention.
Figure 3 shows a cross-section of the module of Figure 2 when the sunlight is incident perpendicular to the lenses.
Figure 4 shows a cross-section of the module of Figure 2 when the sunlight is not incident perpendicular to the lenses.
Figure 5 shows a perspective view of a second example of embodiment of a photovoltaic solar concentration module according to the invention.
Figure 6 shows a cross-section of the module of Figure 5 when the sunlight is incident perpendicular to the lenses.
Figure 7 shows a cross-section of the module of Figure 5 when the sunlight is not incident perpendicular to the lenses.
Figure 8 shows a perspective view of the plate that contains the photovoltaic cells.

### PREFERRED EMBODIMENT OF THE INVENTION

In view of the foregoing, the present invention relates to a photovoltaic solar concentration module provided with a housing (1) in the form of two truncated pyramids (1.1, 1.2) joined at their minor base, such that the inner surface of the photovoltaic solar concentration module is only covered by metallic plates (2) at the lower truncated pyramid (1.1), which is the area reached by the sunlight.

On the top base (1.2.1) of the module, the greater base of the upper truncated pyramid (1.2), a set of lenses (3) is arranged allowing to converge the sunlight (4) toward a set of photovoltaic cells (5) arranged in the bottom base (1.1.1) of the lower truncated pyramid (1.1).

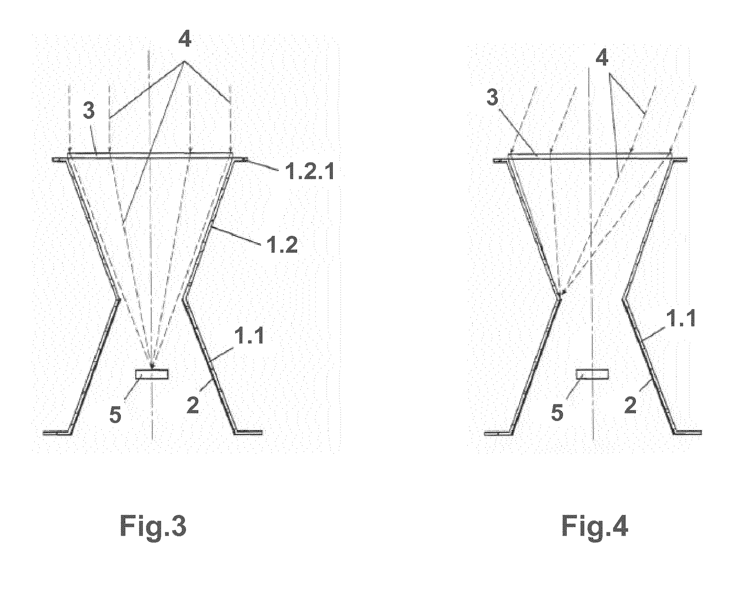

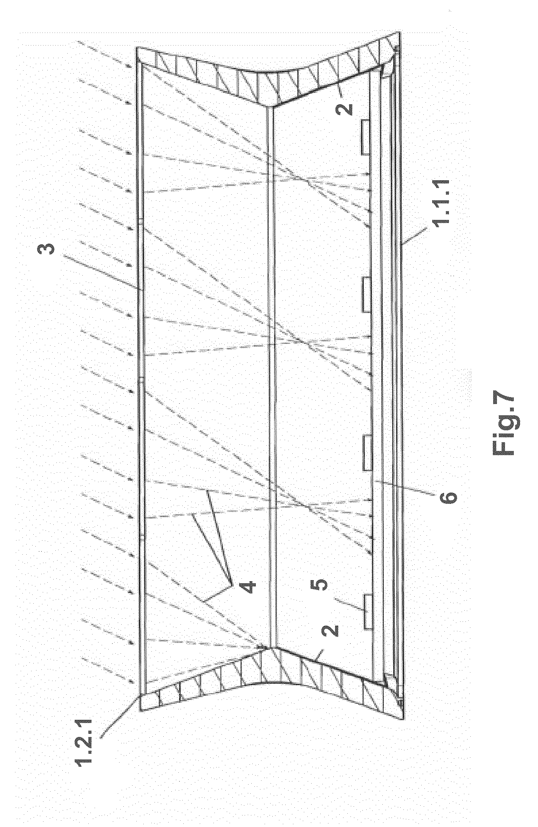

The ratio of the focal length of the lenses (3) placed on the top base (1.2.1) to the radius of the same remains constant, such that when the solar concentration module does not track the sun correctly, the sunlight is incident on only the inner surface of the lower truncated pyramid (1.1) as shown in figures 4 and 7.

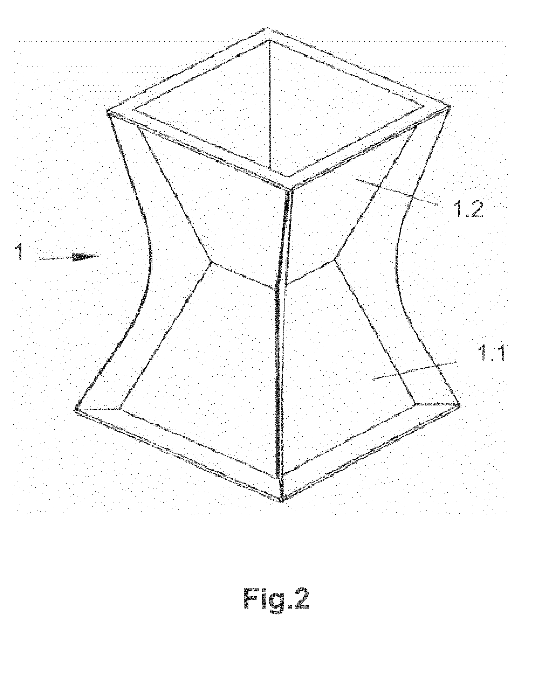

In a first example of a preferred embodiment, shown in figures 2 to 4, the bases (1.1.1, 1.2.1) of the pyramids (1.1, 1.2) are equal and square.

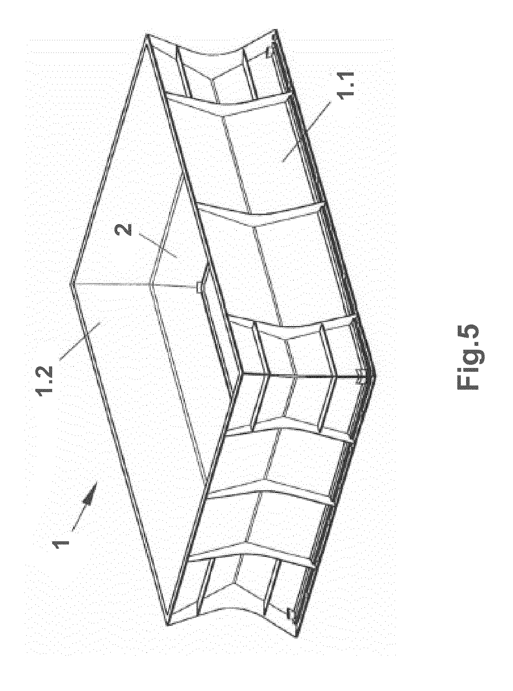

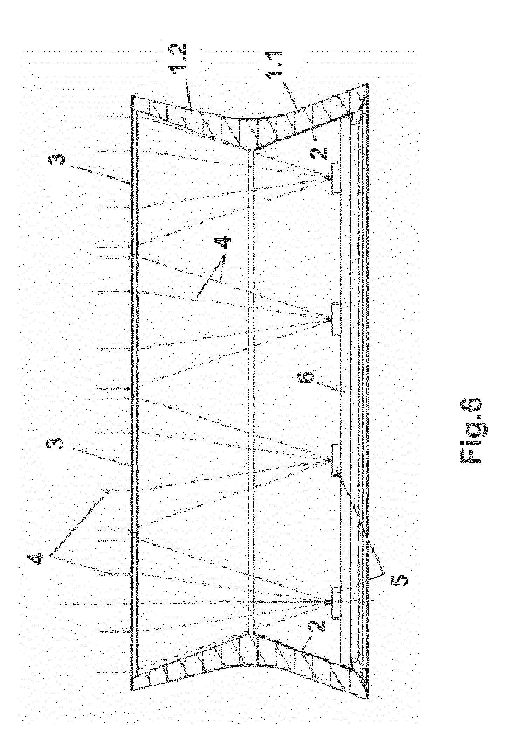

In a second example of a preferred embodiment, shown in figures 5 to 7, the bases (1.1.1, 1.2.1) of the pyramids (1.1, 1.2) are equal and rectangular.

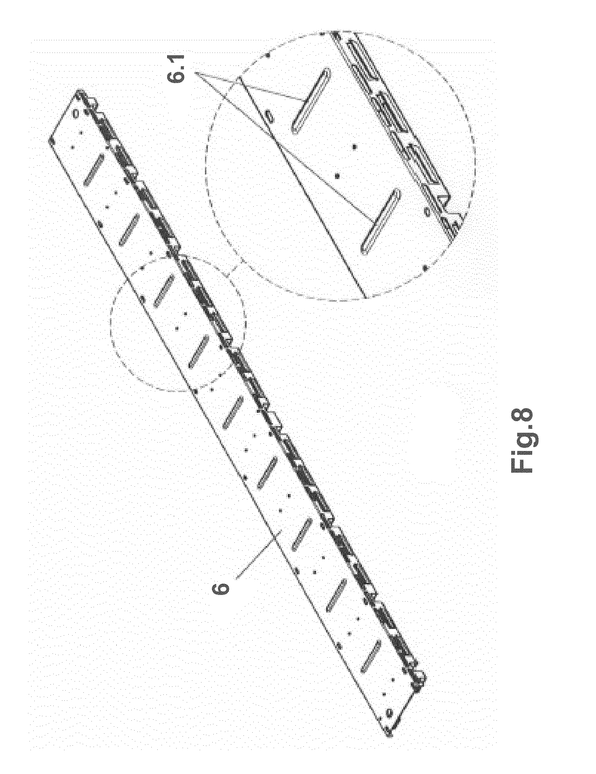

In both examples of preferred embodiments the photovoltaic module does not have a base, that is, there is no bottom base (1.1.1), and instead a plate (6) is provided which contains the photovoltaic cells (5), as shown in figure 8.

Said plate (6) has orifices (6.1) that facilitate the cooling of the photovoltaic cells (5), avoiding the need to install heat dissipators in each of the cells (5).

The essence of this invention is not affected by variations in the materials, shape, size, and arrangement of its component elements, described in a non-limiting manner such that a person skilled in the art would be able to reproduce the invention.

## Claims

1. Photovoltaic solar concentration module that has a plastic housing with a set of lenses (3) which allow converging sunlight toward a group of photovoltaic cells (5) arranged inside the module, **characterised in that** the housing has two truncated pyramids (1.1, 1.2) joined at their minor base, wherein the inner surface of the photovoltaic solar concentration module is only covered with metallic plates (2) at the lower truncated pyramid (1.1), which is the area reached by the sunlight.

2. Photovoltaic solar concentration module according to claim 1 **characterised in that** the ratio of the focal length of the lenses (3) arranged in the module to the radius of the same (3) remains constant.

3. Photovoltaic solar concentration module according to claim 1 **characterised in that** the lenses are arranged in the top base (1.2.1) of the module, the greater base of the upper truncated pyramid (1.2) and the photovoltaic cells are arranged on the bottom base (1.1.1) of the lower truncated pyramid (1.1).

4. Photovoltaic solar concentration module according to claim 3, **characterised in that** the bases (1.1.1, 1.2.1) of the pyramids (1.1, 1.2) are equal and square.

5. Photovoltaic solar concentration module according to claim 3 **characterised in that** the bases (1.1.1, 1.2.1) of the pyramids (1.1, 1.2) are equal and rectangular.

6. Photovoltaic solar concentration module according to any of the preceding claims **characterised in that** the photovoltaic module does not have a base, and instead is provided with a plate (6) containing the photovoltaic cells (5).

7. Photovoltaic solar concentration module according to claim 1 **characterised in that** the plate (6) has some orifices (6.1) that facilitate the cooling of the photovoltaic cells (5).
